# DEMANDE DE BREVET EUROPEEN

(11) **EP 3 168 696 A1**
(43) Date de publication de la demande: **17.05.2017**
(21) Numéro de dépôt: 15194156.4
(22) Date de dépôt: 11.11.2015
(51) Int. Cl.: G04D 3/00, G04B 19/10, B81C 1/00, B44C 1/22

(54) **PROCÉDÉ DE FABRICATION D'UNE PIÈCE À BASE DE SILICIUM AVEC AU MOINS UN MOTIF À ILLUSION D'OPTIQUE**

(71) Demandeur: Nivarox-FAR S.A., 2400 Le Locle (CH)
(72) Inventeur: Cusin, Pierre, 1423 Villars-Burquin (CH); Gandelhman, Alex, 2000 Neuchâtel (CH)
(74) Mandataire: Goulette, Ludivine

(57) **Abrégé**

L'invention se rapporte à un procédé de fabrication d'une pièce monobloc de forme simple à base de silicium offrant l'illusion d'un facettage et/ou d'un chanfreinage pour former tout ou partie de l'habillage d'une pièce d'horlogerie.

## Description

### Domaine de l'invention

L'invention se rapporte à un procédé de fabrication d'une pièce à base de silicium comportant au moins un motif à illusion d'optique et, plus précisément, au moins un motif faisant croire que la surface supérieure n'est pas plane ou comporte deux types de matériau.

### Arrière-plan de l'invention

Il est connu de former des pièces d'habillage dont la surface supérieure est facettée et/ou chanfreinée afin d'améliorer l'esthétique d'une pièce d'horlogerie. Le document EP 1 722 281 divulgue un procédé de fabrication de pièces facettées en silicium ne nécessitant pas d'étape de retouche.

### Résumé de l'invention

Le but de la présente invention est de pallier tout ou partie les inconvénients cités précédemment en proposant un procédé de fabrication ne nécessitant ni facettage ni retouche pour obtenir une pièce plus simple à base de silicium offrant l'illusion d'un facettage et/ou d'un chanfreinage et/ou d'une pièce composite.

A cet effet, l'invention se rapporte à un procédé de fabrication d'une pièce à base de silicium avec au moins un motif à illusion d'optique caractérisé en ce qu'il comporte les étapes suivantes :
a) former un substrat comportant une couche à base de silicium ;
b) graver des trous traversants l'épaisseur de la couche à base de silicium pour former le contour de la pièce et des évidements borgnes dans l'épaisseur de la couche à base de silicium afin de former la pièce avec au moins un motif à illusion d'optique ;
c) libérer la pièce ainsi formée du substrat.

On comprend donc que le procédé de fabrication permet, grâce à la planéité de la couche à base de silicium, d'obtenir une pièce dont la surface supérieure plane n'a pas besoin d'être facettée ou, plus globalement, retouchée.

De plus, le procédé de fabrication offre une très grande précision des cotes et très grande reproductibilité d'une même pièce monobloc à base de silicium ou de plusieurs pièces monoblocs différentes à base de silicium sur un même substrat.

Enfin, la très grande précision et la très grande reproductibilité du procédé de fabrication permet, avantageusement selon l'invention, d'obtenir une pièce très simple munie d'au moins un motif très fin et facilement reproductible faisant croire que la surface supérieure n'est pas plane à la manière d'un usinage comme un biseautage ou un chanfreinage.

Conformément à d'autres variantes avantageuses de l'invention :
- selon un premier mode de réalisation, les évidements borgnes forment au moins deux séries de segments parallèles, la première série de segments parallèles joignant la deuxième série de segments parallèles selon un angle compris entre 10 et 170 degrés afin d'offrir à ladite pièce l'illusion d'une face supérieure avec deux faces biseautées formant une arête ;
- selon un deuxième mode de réalisation, les évidements borgnes forment au moins une série de segments courbes afin d'offrir à ladite pièce l'illusion d'une face supérieure avec une face bombée ;
- selon un troisième mode de réalisation, les évidements borgnes forment au moins une série d'évidements distribués symétriquement les uns par rapport aux autres, ladite au moins une série d'évidements étant formée adjacente à une partie dont la surface de la pièce ne comporte aucun évidement afin d'offrir à ladite pièce l'illusion d'une face supérieure avec deux faces biseautée formant une arête ;

- selon un quatrième mode de réalisation, les évidements borgnes sont distribuée à la périphérie de la pièce et forment au moins deux séries de segments parallèles, les segments parallèles de la première série étant perpendiculaires aux segments et se joignant selon un angle à 90 degrés afin d'offrir à ladite pièce l'illusion d'une face supérieure chanfreinée ;
- selon un cinquième mode de réalisation, les évidements borgnes forment au moins une série d'évidements distribués symétriquement les uns par rapport aux autres, ladite au moins une série d'évidements étant bordée par des surfaces de la pièce ne comportant aucun évidement afin d'offrir à ladite pièce l'illusion d'une face supérieure sombre bordée par un autre matériau plus clair ;
- les évidements borgnes ont une profondeur comprise entre 2 et 100 µm ;
- le procédé comporte en outre, entre l'étape b) et l'étape c), l'étape d) : former des trous traversants dans l'épaisseur du reste du substrat afin de former une pièce avec un moyen de fixation ;
- la couche à base de silicium comporte une épaisseur comprise entre 50 et 500 µm ;
- selon une première alternative, l'étape b) comporte les phases e) : former un masque avec des ouvertures sur la couche à base de silicium, les ouvertures utilisées pour former les trous traversants étant plus larges que celles utilisées pour former les évidements borgnes, f) : graver à l'aide d'une attaque anisotrope la couche à base de silicium selon les ouvertures du masque et g) : retirer le masque ;
- selon une deuxième alternative, l'étape b) comporte les phases h) : former un premier masque avec des ouvertures selon les formes des trous traversants et des évidements borgnes, i) : former un deuxième masque sur le premier masque avec des ouvertures uniquement selon les formes des trous traversants, j) : graver partiellement, à l'aide d'une première attaque anisotrope, la couche à base de silicium selon les ouvertures du deuxième masque, k) : retirer le deuxième masque, I) : graver, à l'aide d'une deuxième attaque anisotrope, la couche à base de silicium selon les ouvertures du premier masque de manière à obtenir les trous traversants et les évidements borgnes et m) : retirer le premier masque ;
- la pièce à base de silicium comporte du silicium monocristallin, du silicium monocristallin dopé, du silicium amorphe, du silicium poreux, du silicium polycristallin, du nitrure de silicium, du carbure de silicium, du quartz ou de l'oxyde de silicium ;
- plusieurs pièces sont formées dans la même couche à base de silicium ;
- la pièce forme tout ou partie d'un cadran, d'un décoration de guichet, d'un réhaut, d'une lunette, d'un poussoir, d'une couronne, d'un fond de boîtier, d'une aiguille, d'un bracelet, d'un maillon, d'un fermoir, d'un décor, d'une masse oscillante ou d'une applique.

L'invention se rapporte également à l'habillage d'une pièce d'horlogerie comportant une pièce à base de silicium obtenue à partir du procédé selon l'une des variantes précédentes, caractérisé en ce que la pièce comporte une surface supérieure sensiblement plane avec au moins un motif à illusion d'optique faisant croire que la surface supérieure n'est pas plane.

### Description sommaire des dessins

D'autres particularités et avantages ressortiront clairement de la description qui en est faite ci-après, à titre indicatif et nullement limitatif, en référence aux dessins annexés, dans lesquels :
- les figures 1 à 5 sont des représentations d'étapes de procédés selon l'invention ;
- les figures 6 à 11 représentent des exemples d'aiguilles obtenues selon l'invention ;
- les figures 12 à 18 représentent des exemples d'heures index obtenus selon l'invention ;
- la figure 19 représente un exemple de décoration de guichet obtenu selon l'invention.

### Description détaillée des modes de réalisation préférés

La présente invention se rapporte à un procédé de fabrication d'une pièce monobloc de forme simple à base de silicium offrant l'illusion d'un facettage et/ou d'un chanfreinage pour former tout ou partie de l'habillage d'une pièce d'horlogerie. A titre d'exemple nullement limitatif, la pièce peut ainsi former tout ou partie d'un cadran, d'une décoration de guichet, d'un réhaut, d'une lunette, d'un poussoir, d'une couronne, d'un fond de boîtier, d'une masse oscillante, d'une aiguille, d'un bracelet, d'un maillon, d'un fermoir, d'un décor ou d'une applique.

Bien entendu, une telle pièce ne saurait se limiter au domaine de l'horlogerie. A titre d'exemple nullement limitatif, une telle pièce pourrait alternativement former tout ou partie d'un article de bijouterie ou de joaillerie.

Le procédé est destiné à fabriquer une pièce à base de silicium. Le terme « à base de silicium » signifie que le silicium seul ou sous forme d'un composé peut entrer dans la composition de la pièce. Ainsi, à titre d'exemple nullement limitatif, la pièce peut par exemple être formée avec du silicium monocristallin quelle que soit son orientation cristalline, du silicium monocristallin dopé quelle que soit son orientation cristalline, du silicium amorphe, du silicium poreux, du silicium polycristallin, du nitrure de silicium, du carbure de silicium, du quartz quelle que soit son orientation cristalline ou de l'oxyde de silicium.

Avantageusement selon l'invention, la pièce à base de silicium obtenue par le procédé comporte au moins un motif à illusion d'optique. Plus précisément, la pièce comporte, de manière avantageuse, une surface supérieure sensiblement plane avec au moins un motif à illusion d'optique faisant croire que la surface supérieure n'est pas plane ce qui permet d'avoir une pièce simple offrant, par exemple, l'illusion d'un facettage et/ou d'un chanfreinage et/ou d'une pièce composite.

Par soucis de simplification, les figures présentées montrent la fabrication d'une seule pièce sur un substrat. Toutefois, avantageusement selon l'invention, le procédé autorise plusieurs pièces identiques ou différentes à être formées sur le même substrat.

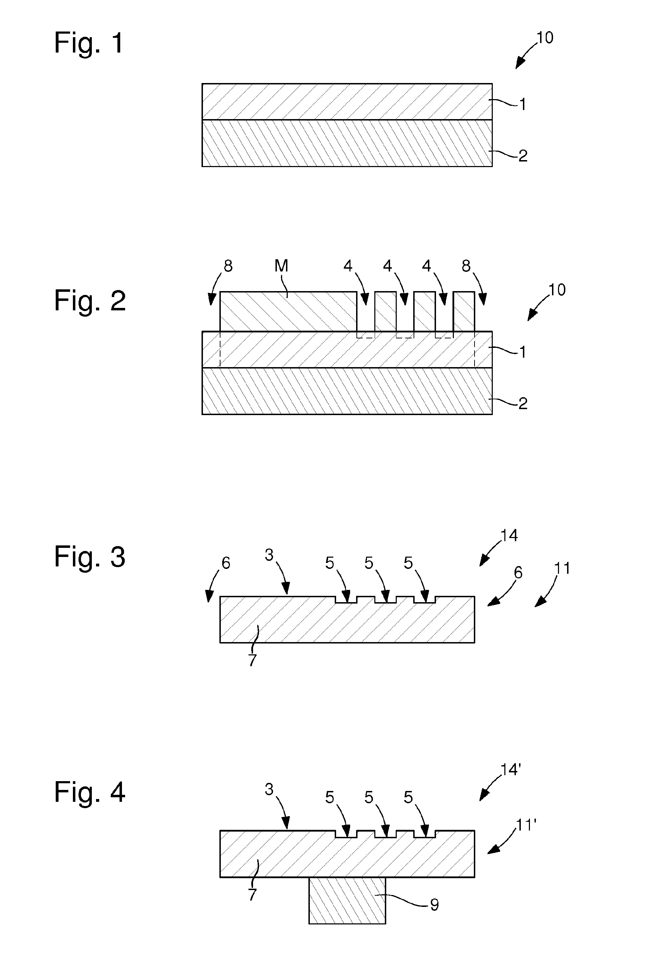

Comme visible à la figure 1, le procédé selon l'invention comporte une première étape a) destinée à former un substrat 10 comportant une couche 1 à base de silicium dont l'épaisseur est comprise entre 50 et 500 µm. Dans l'exemple illustré à la figure 1, on remarque que le substrat 10 comporte en outre une couche 2 de support destinée à recevoir la couche 1 à base de silicium. Suivant les variantes expliquées ci-dessous, la couche 2 de support peut être choisie quant au matériau utilisé ou être de nature totalement indifférente.

Comme illustré à la figure 2, le procédé se poursuit avec une deuxième étape b) destinée à graver des trous 6 traversants l'épaisseur de la couche 1 à base de silicium pour former le corps 7 de la pièce 11 et des évidements 5 borgnes dans l'épaisseur de la couche 1 à base de silicium afin de former la pièce 11 avec au moins un motif 14 à illusion d'optique.

La forme générale dudit au moins un motif à illusion d'optique sera mieux expliquée ci-dessous. Pour des raisons d'intelligibilité, les évidements 5 sont représentés schématiquement à la figure 2 en pointillés par trois creux dans la surface supérieure 3 de la couche 1 à base de silicium.

De plus, les évidements 5 pratiqués dans la couche 1 peuvent s'étendre selon une profondeur comprise entre 2 et 100 µm à partir de la surface supérieure 3 de la couche 1 à base de silicium.

Comme illustré à la figure 2, l'étape b) comporte, selon une première alternative préférée, trois phases e) à g). L'étape b) comporte une première phase e) destinée à former un masque M avec des ouvertures 4, 8 sur la couche 1 à base de silicium. Préférentiellement, les ouvertures 8 utilisées pour former les trous 6 traversants sont plus larges que celles 4 utilisées pour former les évidements 5 borgnes. Une telle phase e) peut, par exemple, être obtenue par photolithographie d'une résine photosensible, par structuration d'une couche comme de l'oxyde de silicium ou par dépôt sélectif d'une couche de métal ou de nitrure de silicium. Bien entendu, d'autres procédés de formation et/ou d'autres matériaux du masque sont possibles.

La première alternative préférée se poursuit avec une deuxième phase f) est destinée à graver, à l'aide d'une attaque anisotrope, la couche 1 à base de silicium selon les ouvertures 4, 8 du masque M. On comprend donc que l'attaque anisotrope, comme par exemple un gravage ionique réactif profond, enlèvera plus profondément le matériau à base de silicium dans les ouvertures 8 plus larges que dans les ouvertures 4. Cette différence de vitesse de gravage permet avantageusement de former en une même attaque des trous 6 traversants et des évidements 5 borgnes dans la couche 1 à base de silicium.

Enfin, l'étape b), selon la première alternative préférée, se termine avec une troisième phase g) destinée à retirer le masque M. Cette troisième phase g) est généralement obtenue par une attaque chimique sélective du matériau utilisé pour le masque M.

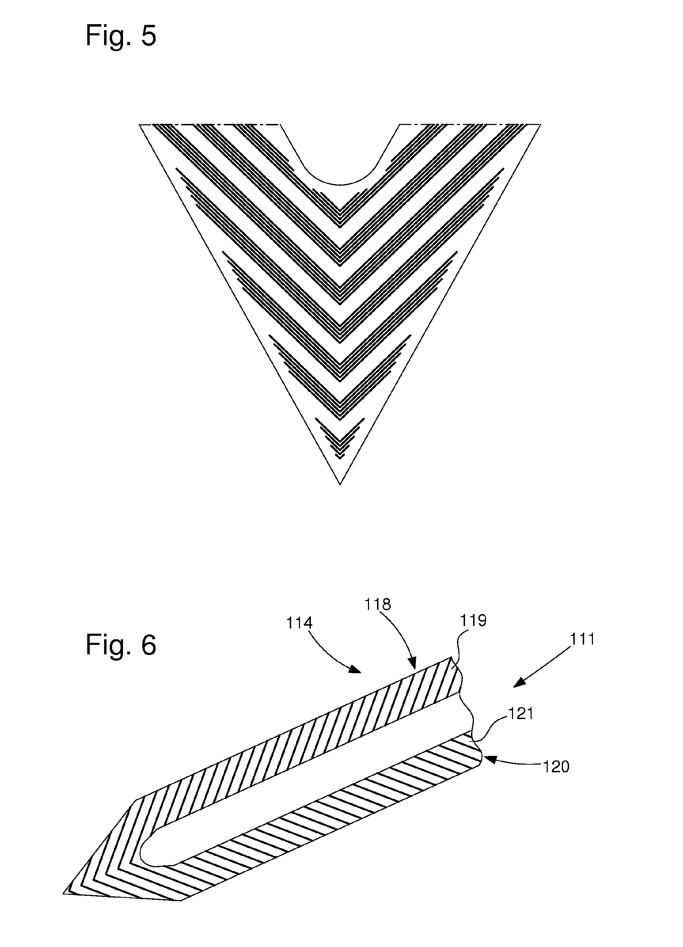

Selon une variante de la première alternative, les ouvertures 4 correspondant à la forme des futurs évidements 5 borgnes sont divisées en des ouvertures plusieurs fois plus petites comme illustré à la figure 5. Puis après la phase g), l'étape b) comporte une phase d'oxydation de la couche 1 à base de silicium destinée à oxyder totalement les parois le plus minces illustrées à la figure 5 qui sont formées uniquement au niveau des futurs évidements 5 borgnes souhaités. Enfin, l'étape b) se termine par la désoxydation de la couche 1 à base de silicium destinée à former les évidements 5 borgnes. Cette variante est particulièrement utile quand les évidements 5 borgnes sont voulus bien moins profonds que les trous 6 traversants.

Selon une deuxième alternative non représentée, l'étape b) comporte, les six phases h) à m). L'étape b) comporte ainsi une première phase h) destinée à former un premier masque avec des ouvertures 4, 8 selon les formes des trous 6 traversants et des évidements 5 borgnes. La deuxième alternative se poursuit avec une deuxième phase i) destinée à former un deuxième masque sur le premier masque avec des ouvertures 8 uniquement selon les formes des trous 6 traversants. On comprend donc que les ouvertures 4 du premier masque sont cachées par le deuxième masque.

La deuxième alternative comporte ensuite une troisième phase j) destinée à graver partiellement, c'est-à-dire selon une partie de l'épaisseur uniquement, à l'aide d'une première attaque anisotrope, la couche 1 à base de silicium selon les ouvertures 8 des premier et deuxième masques. Dans une quatrième phase k), le deuxième masque est retiré puis une cinquième phase I) est destinée à graver, à l'aide d'une deuxième attaque anisotrope, la couche 1 à base de silicium selon les ouvertures 4, 8 du premier masque de manière à obtenir les trous 6 traversants et les évidements 5 borgnes. Enfin, la deuxième alternative se termine avec la phase m) destinée à retirer le premier masque. Même sans être représentée, on comprend que cette deuxième alternative permet d'obtenir le même résultat que la première alternative.

Selon une troisième alternative non représentée, l'étape b) comporte des phases successives de gravage des trous 6 traversants et des évidements 5 borgnes, c'est-à-dire, soit d'abord le gravage des trous 6 traversants puis des évidements 5 borgnes, soit l'inverse. A titre d'exemple, l'étape b) selon la troisième alternative pourrait ainsi comporter deux processus comprenant des phases similaires aux phases e) à g) expliquées ci-dessous, chaque processus étant destiné à graver les trous 6 traversants ou les évidements 5 borgnes. Par conséquent, on comprend que cette troisième alternative permet également d'obtenir le même résultat que la première alternative.

Avantageusement selon l'invention, le procédé permet, grâce à l'étape b) très précise de photolithographie, d'obtenir un corps 7 à base de silicium avec des cotes externes et, éventuellement, internes d'une grande précision propre à respecter les tolérances très élevées d'une pièce dans le domaine de l'horlogerie. Par cotes internes, il faut comprendre que des trous 6 traversants pourraient également être formés dans le corps 7 lors de l'étape b) pour y recevoir ultérieurement un organe.

Enfin, le procédé se termine avec une troisième et dernière étape c) destinée à libérer la pièce 11 ainsi formée du substrat 10. Par conséquent, l'étape c) peut consister en une attaque sélective de la couche 2 de support.

Selon une autre variante du procédé illustrée à la figure 4, le procédé peut comporter en outre, entre l'étape b) et l'étape c), l'étape optionnelle d) destinée à former des trous traversants dans l'épaisseur du reste du substrat 10 afin de former une pièce 11' avec un moyen 9 de fixation.

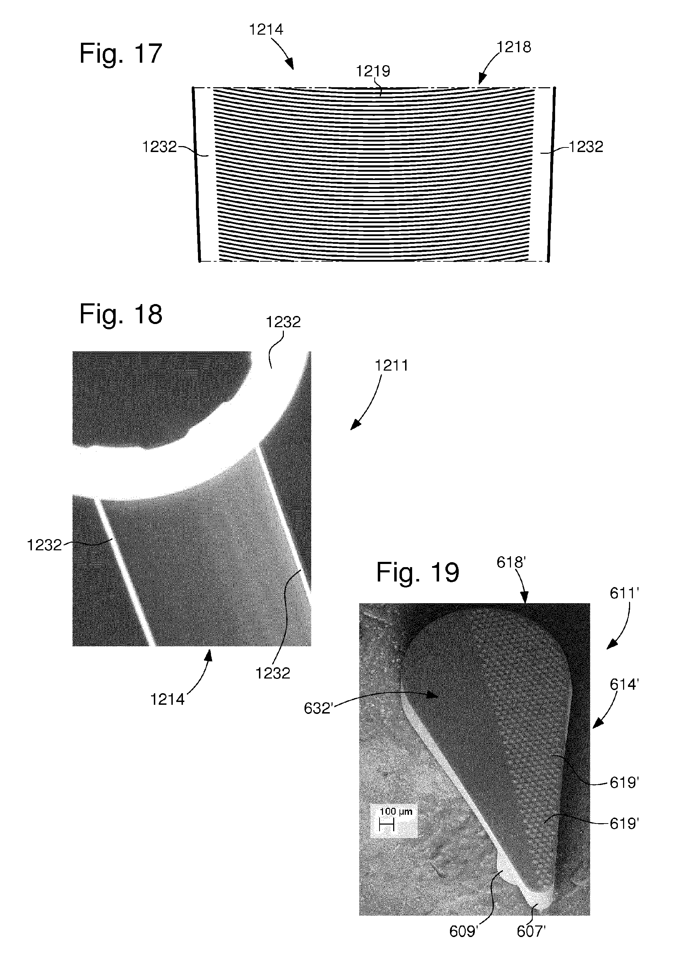

Du fait du positionnement précis de chaque corps 7 sur le substrat 10, il est possible, lors de l'étape d), de graver la couche 2 du substrat 10 selon des cotes précises. Dans cette variante, la couche 2 de support est préférentiellement à base de silicium afin d'utiliser les mêmes types de gravage que pour l'étape b) décrite ci-dessus. Une telle étape d) permet avantageusement selon l'invention d'obtenir une pièce 611' comme décrite ci-dessous en relation avec la figure 18.

On comprend alors, qu'en plus de la surface supérieure 3 plane et des évidements 5 formant ledit au moins un motif 14, 614' à illusion d'optique, la pièce 11', 611' comporte en outre au moins un moyen 9, 609' de fixation destiné à attacher la pièce 11', 611'. Le moyen 9, 609' de fixation peut ainsi prendre la forme d'un pied ou d'un canon.

Les figures 6 à 19 représentent des exemples de pièces obtenues selon le procédé permettant de mieux expliquer un motif à illusion d'optique selon l'invention. A titre nullement limitatif, il est expliqué quatre modes de réalisation de motif à illusion d'optique.

Selon un premier mode de réalisation, le motif 114, 214, 514 et 714 à illusion d'optique des figures 6, 7, 12 et 16 forme ainsi au moins deux séries 118, 120, 218, 220, 518, 520, 718, 720 de segments 119, 121, 219, 221, 519, 521, 719, 721 parallèles. Préférentiellement selon le premier mode de réalisation, la première série 118, 218, 518, 718 de segments 119, 219, 519, 719 parallèles joignant la deuxième série 120, 220, 520, 720 de segments 121, 221, 521, 721 parallèles selon un angle compris entre 10 et 170 degrés afin d'offrir à la pièce 111, 211, 511, 711 l'illusion d'une face supérieure avec deux faces biseautées formant une arête alors qu'elle est plane.

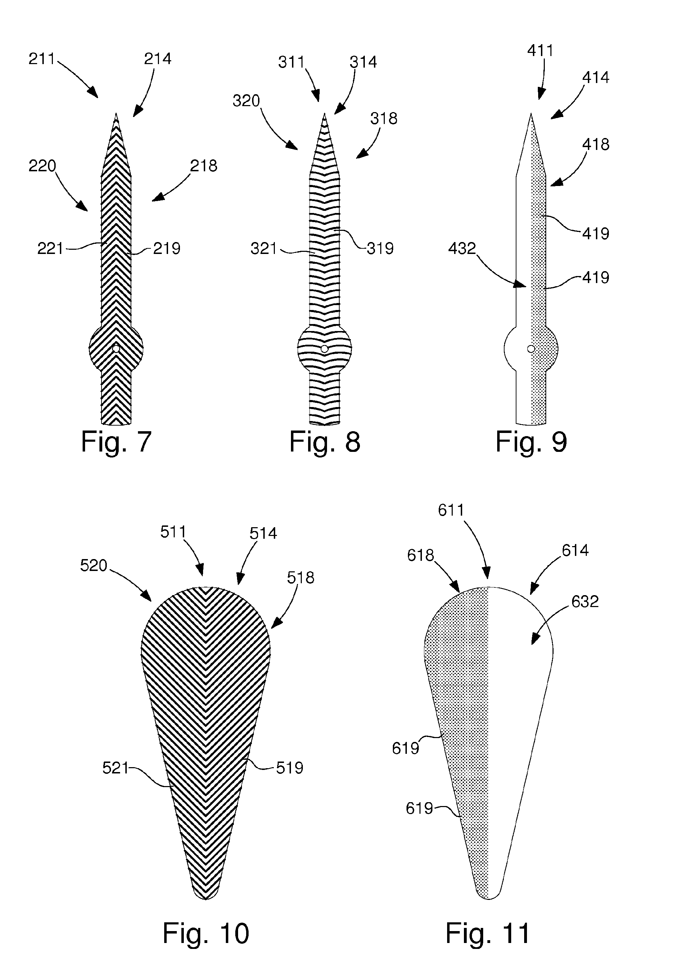

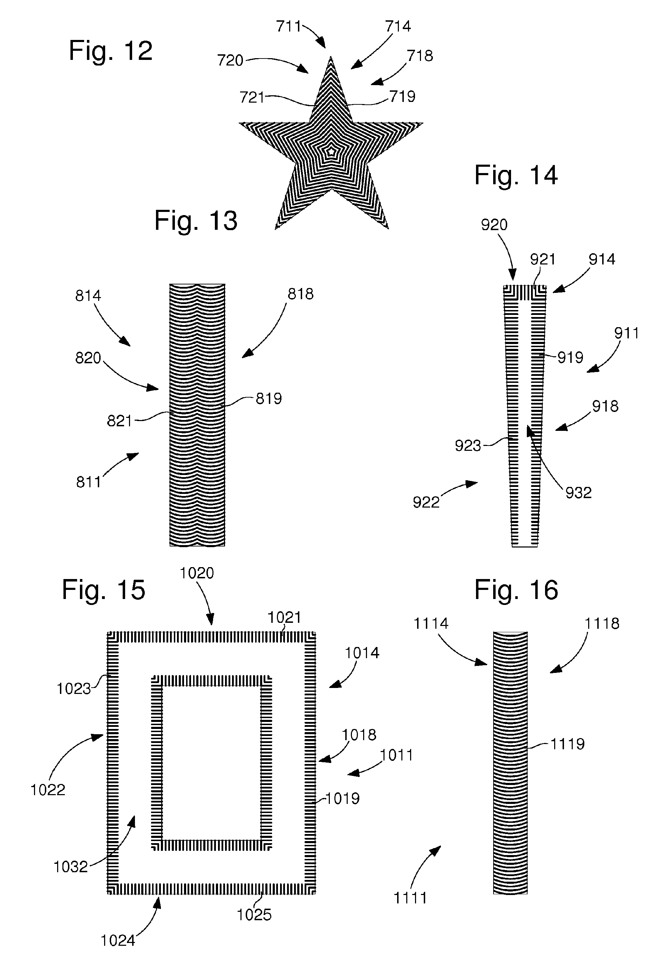

Selon un deuxième mode de réalisation, le motif 314, 814 et 1114 à illusion d'optique des figures 8, 13 et 15 forme ainsi au moins une série 318, 320, 818, 820, 1118 de segments 319, 321, 819, 821, 1119 courbes afin d'offrir à ladite pièce l'illusion d'une face supérieure bombée alors qu'elle est plane. Selon une variante du deuxième mode de réalisation visible aux figures 8 et 13, une première série 318, 818 de segments 319, 819 courbes joint une deuxième série 320, 820 de segments 321, 821 courbes selon un angle compris entre 10 et 170 degrés afin d'offrir à ladite pièce l'illusion d'une face supérieure avec deux faces bombées formant une rainure alors que la face supérieure est plane.

Selon un troisième mode de réalisation, le motif 414 et 614 à illusion d'optique des figures 9 et 17 forme ainsi au moins une série 418, 618 d'évidements 419, 619 distribués symétriquement les uns par rapport aux autres. Préférentiellement selon le troisième mode de réalisation, ladite au moins une série 418, 618 d'évidements étant formée adjacente à une partie 432, 632 dont la surface de la pièce 411, 611 ne comporte aucun motif à illusion d'optique afin d'offrir à ladite pièce l'illusion d'une face supérieure avec deux faces biseautée formant une arête alors qu'elle est plane.

Comme visible aux figures 9 et 17, les évidements 419, 619 sont de section circulaire et régulièrement espacés entre eux. Bien entendu, la géométrie et la distribution des évidements 419, 619 peuvent différer suivant l'effet souhaité sans sortir du cadre de l'invention.

Selon un quatrième mode de réalisation, le motif 914 et 1014 à illusion d'optique des figures 14 et 19 est distribué à la périphérie de la pièce 911, 1011 et forme ainsi au moins deux séries 918, 920, 922, 1018, 1020, 1022, 1024 de segments 919, 921, 923, 1019, 1021, 1023, 1025 parallèles, les segments 919, 923, 1019, 1023 parallèles de la première série 918, 922, 1018, 1022 étant perpendiculaires aux segments 921, 1021, 1025 parallèles de la deuxième série 920, 1020, 1024 et se joignant selon un angle à 90 degrés afin d'offrir à la pièce l'illusion d'une face supérieure chanfreinée entourant une partie 932, 1032 dont la surface de la pièce 911, 1011 ne comporte aucun motif à illusion d'optique.

Selon un cinquième mode de réalisation illustré aux figures 10 et 11, le motif 1214 à illusion d'optique forme au moins une série 1218 d'évidements 1219 distribués symétriquement les uns par rapport aux autres comme mieux visible à la figure 10. Ladite au moins une série 1219 d'évidements étant bordée par des surfaces 1232 de la pièce 1211 ne comportant aucun évidement afin d'offrir à la pièce 1211 l'illusion, comme illustré à la figure 11, d'une face supérieure sombre bordée par un autre matériau plus claire alors que la pièce ne comporte qu'un seul matériau à base de silicium. On comprend en fait que le motif 1214 à illusion d'optique se comporte comme un piège de lumière qui limite la réflexion contrairement aux surfaces 1232.

Selon une variante du cinquième mode de réalisation, la pièce 1211 est en plus recouverte d'une couche de réflexion, comme par exemple à base de chrome, afin d'améliorer encore le contraste entre la zone sombre formée par le motif 1214 à illusion d'optique et la (ou les) surface(s) 1232 sans motif.

Bien entendu, la présente invention ne se limite pas à l'exemple illustré mais est susceptible de diverses variantes et modifications qui apparaîtront à l'homme de l'art. En particulier, les motifs 14, 114, 214, 314, 414, 514, 614, 714, 814, 914, 1014, 1114 à illusion d'optique ne sauraient se limiter à ceux décrits ci-dessus. Ainsi, d'autres modes de réalisation sont possibles sans sortir du cadre de l'invention.

Ainsi, dans une alternative particulière du troisième mode de réalisation illustrée à la figure 19, le motif 614' à illusion d'optique forme au moins une série 618' d'évidements 619' distribués symétriquement les uns par rapport aux autres. Comme visible à la figure 19, ladite au moins une série 618' d'évidements est formée adjacente à une partie 632' dont la surface de la pièce 611' ne comporte aucun motif à illusion d'optique afin d'offrir à ladite pièce l'illusion d'une face supérieure avec deux faces biseautée formant une arête alors qu'elle est plane.

Les évidements 619' sont de volume pyramidal tronqué à base carrée et régulièrement espacés entre eux. Cette alternative particulière est obtenue avec une couche 1 en silicium monocristallin orienté selon le plan (100). De plus, l'étape b) utilise un gravage humide à l'hydroxyde de potassium (KOH) permettant de former des gravures dont les flancs sont obliques et non verticaux comme illustré aux figures 1 à 3. En effet, même avec un masque de gravage offrant des ouvertures discoïdales, le gravage humide suit les mailles de la structure cristallographique de la couche 1 en silicium monocristallin orienté selon le plan (100) en donnant une gravure pyramidale à base carrée.

De plus, comme visible à la figure 18, le substrat 10 étant du type silicium sur isolant (abréviation anglaise « S.O.I. »), la couche 2 également en silicium monocristallin est également gravée, par exemple par une attaque sèche ou humide, afin d'obtenir plusieurs pieds 609' destinés à fixer la pièce 611'.

Enfin, les cinq modes de réalisation présentés ci-dessus sont susceptibles d'être combinés entre eux, c'est-à-dire que plusieurs motifs différents peuvent apparaître sur la même pièce.

## Revendications

1. Procédé de fabrication d'une pièce (11, 111, 211, 311, 411, 511, 611, 611', 711, 811, 911, 1011, 1111, 1211) à base de silicium avec au moins un motif (14, 114, 214, 314, 414, 514, 614, 614', 714, 814, 914, 1014, 1114, 1214) à illusion d'optique **caractérisé en ce qu'**il comporte les étapes suivantes :
a) former un substrat (10) comportant une couche (1) à base de silicium ;
b) graver des trous (6) traversants l'épaisseur de la couche (1) à base de silicium pour former le contour de la pièce (11, 111, 211, 311, 411, 511, 611, 611', 711, 811, 911, 1011, 1111, 1211) et des évidements (5) borgnes dans l'épaisseur de la couche (1) à base de silicium afin de former la pièce (11, 111, 211, 311, 411, 511, 611, 611', 711, 811, 911, 1011, 1111, 1211) avec au moins un motif (14, 114, 214, 314, 414, 514, 614, 614', 714, 814, 914, 1014, 1114, 1214) à illusion d'optique ;
c) libérer la pièce (11, 111, 211, 311, 411, 511, 611, 611', 711, 811, 911, 1011, 1111, 1211) ainsi formée du substrat (10).

2. Procédé selon la revendication précédente, **caractérisé en ce que** les évidements (5) borgnes forment au moins deux séries de segments parallèles, la première série (118, 218, 518, 718) de segments (119, 219, 519, 719) parallèles joignant la deuxième série (120, 220, 520, 720) de segments (121, 221, 521, 721) parallèles selon un angle compris entre 10 et 170 degrés afin d'offrir à ladite pièce l'illusion d'une face supérieure avec deux faces biseautées formant une arête.

3. Procédé selon la revendication 1, **caractérisé en ce que** les évidements (5) borgnes forment au moins une série (318, 320, 818, 820, 1118) de segments (319, 321, 819, 821, 1119) courbes afin d'offrir à ladite pièce l'illusion d'une face supérieure avec une face bombée.

4. Procédé selon la revendication 1, **caractérisé en ce que** les évidements (5) borgnes forment au moins une série (418, 618) d'évidements (419, 619) distribués symétriquement les uns par rapport aux autres, ladite au moins une série d'évidements étant formée adjacente à une partie (432, 632) dont la surface de la pièce (11, 111, 211, 311, 411, 511, 611, 611', 711, 811, 911, 1011, 1111, 1211) ne comporte aucun évidement afin d'offrir à ladite pièce l'illusion d'une face supérieure avec deux faces biseautée formant une arête.

5. Procédé selon la revendication 1, **caractérisé en ce que** les évidements (5) borgnes sont distribuée à la périphérie de la pièce (11, 111, 211, 311, 411, 511, 611, 611', 711, 811, 911, 1011, 1111, 1211) et forment au moins deux séries de segments parallèles, les segments (919, 923, 1019, 1023) parallèles de la première série (918, 922, 1018, 1022) étant perpendiculaires aux segments (921, 1021, 1025) parallèles de la deuxième série (920, 1020, 1024) et se joignant selon un angle à 90 degrés afin d'offrir à ladite pièce l'illusion d'une face supérieure chanfreinée.

6. Procédé selon la revendication 1, **caractérisé en ce que** les évidements (5) borgnes forment au moins une série (1218) d'évidements (1219) distribués symétriquement les uns par rapport aux autres, ladite au moins une série d'évidements étant bordée par des surfaces (1232) de la pièce (11, 111, 211, 311, 411, 511, 611, 611', 711, 811, 911, 1011, 1111, 1211) ne comportant aucun évidement afin d'offrir à ladite pièce l'illusion d'une face supérieure sombre bordée par un autre matériau plus clair.

7. Procédé selon l'une des revendications précédentes, **caractérisé en ce que** les évidements (5) borgnes ont une profondeur comprise entre 2 et 100 µm.

8. Procédé selon l'une des revendications précédentes, **caractérisé en ce que** le procédé comporte en outre, entre l'étape b) et l'étape c), l'étape suivante :
d) former des trous traversants dans l'épaisseur du reste du substrat afin de former une pièce (11, 111, 211, 311, 411, 511, 611, 611', 711, 811, 911, 1011, 1111, 1211) avec un moyen de fixation (9, 609').

9. Procédé selon l'une des revendications précédentes, **caractérisé en ce que** la couche (1) à base de silicium comporte une épaisseur comprise entre 50 et 500 µm.

10. Procédé selon l'une des revendications précédentes, **caractérisé en ce que** l'étape b) comporte les phases suivantes :
e) former un masque (M) avec des ouvertures (4, 8) sur la couche (1) à base de silicium, les ouvertures (8) utilisées pour former les trous (6) traversants étant plus larges que celles (4) utilisées pour former les évidements (5) borgnes ;
f) graver à l'aide d'une attaque anisotrope la couche à base de silicium selon les ouvertures (4, 8) du masque (M) ;
g) retirer le masque (M).

11. Procédé selon l'une des revendications 1 à 9, **caractérisé en ce que** l'étape b) comporte les phases suivantes :
h) former un premier masque avec des ouvertures selon les formes des trous traversants et des évidements borgnes ;
i) former un deuxième masque sur le premier masque avec des ouvertures uniquement selon les formes des trous traversants ;
j) graver partiellement, à l'aide d'une première attaque anisotrope, la couche à base de silicium selon les ouvertures du deuxième masque ;
k) retirer le deuxième masque ;
l) graver, à l'aide d'une deuxième attaque anisotrope, la couche à base de silicium selon les ouvertures du premier masque de manière à obtenir les trous traversants et les évidements borgnes ;
m)retirer le premier masque.

12. Procédé selon l'une des revendications précédentes, **caractérisé en ce que** la pièce (11, 111, 211, 311, 411, 511, 611, 611', 711, 811, 911, 1011, 1111, 1211) à base de silicium comporte du silicium monocristallin, du silicium monocristallin dopé, du silicium amorphe, du silicium poreux, du silicium polycristallin, du nitrure de silicium, du carbure de silicium, du quartz ou de l'oxyde de silicium.

13. Procédé selon l'une des revendications précédentes, **caractérisé en ce que** plusieurs pièces (11, 111, 211, 311, 411, 511, 611, 611', 711, 811, 911, 1011, 1111, 1211) sont formées dans la même couche (1) à base de silicium.

14. Procédé selon l'une des revendications précédentes, **caractérisé en ce que** la pièce (11, 111, 211, 311, 411, 511, 611, 611', 711, 811, 911, 1011, 1111, 1211) forme tout ou partie d'un cadran, d'un décoration de guichet, d'un réhaut, d'une lunette, d'un poussoir, d'une couronne, d'un fond de boîtier, d'une aiguille, d'un bracelet, d'un maillon, d'un fermoir, d'un décor, d'une masse oscillante ou d'une applique.

15. Habillage d'une pièce d'horlogerie comportant une pièce (11, 111, 211, 311, 411, 511, 611, 611', 711, 811, 911, 1011, 1111, 1211) à base de silicium obtenue à partir du procédé selon l'une des revendications précédentes, **caractérisé en ce que** la pièce (11, 111, 211, 311, 411, 511, 611, 611', 711, 811, 911, 1011, 1111, 1211) comporte une surface supérieure sensiblement plane avec au moins un motif (14, 114, 214, 314, 414, 514, 614, 614', 714, 814, 914, 1014, 1114, 1214) à illusion d'optique faisant croire que la surface supérieure n'est pas plane.
